# EUROPÄISCHE PATENTSCHRIFT

(11) **EP 2 301 097 B1**
(45) Veröffentlichungstag und Bekanntmachung des Hinweises auf die Patenterteilung: **12.08.2015**
(21) Anmeldenummer: 10711985.1
(22) Anmeldetag: 04.03.2010
(51) Int. Cl.: H01M 2/30

(54) **ANORDNUNG VON BATTERIEPOLEN EINES ELEKTRISCHEN ENERGIESPEICHERS**
ARRANGEMENT OF BATTERY POLES OF AN ELECTRIC ENERGY ACCUMULATOR
ENSEMBLE DE PÔLES DE BATTERIE D'UN ACCUMULATEUR D'ÉNERGIE ÉLECTRIQUE

(30) Priorität: 09.03.2009 AT 3762009
(43) Veröffentlichungstag der Anmeldung: 30.03.2011
(73) Patentinhaber: Sitte, Alexander, 9020 Klagenfurt (AT)
(72) Erfinder: Sitte, Alexander, 9020 Klagenfurt (AT)
(74) Vertreter: Beer & Partner Patentanwälte KG
(86) Internationale Anmeldenummer: PCT/AT2010/000064
(87) Internationale Veröffentlichungsnummer: WO 2010/102314

(56) Entgegenhaltungen:
- US-A- 5 183 712
- US-A1- 2006 275 656

## Beschreibung

Die Erfindung betrifft einen Stromspeicher (elektrischen Energiespeicher) mit den Merkmalen des einleitenden Teils von Anspruch 1.

Stromspeicher (elektrische Energiespeicher) sind in verschiedenen Ausführungsformen bekannt. Stromspeicher weisen zwei Kontakte auf, nämlich (wenigstens) einen positiven Kontakt und (wenigstens) einen negativen Kontakt, über die der Stromspeicher kontaktiert werden kann, um ihn an einen Verbraucher anzuschließen, einerseits, und ihn in einer Ladestation aufladen zu können, wenn es sich um einen wiederaufladbaren Stromspeicher handelt, andererseits.

Bei den bekannten Ausführungsformen von Stromspeichern, ganz gleich, ob es sich um Stromspeicher mit einer oder mehreren Zellen handelt, ergibt sich stets das Problem, dass auf die richtige Polarität geachtet werden muss, um Beschädigungen eines Gerätes, in dem der Stromspeicher verwendet wird, zu vermeiden, einerseits, und um Beschädigungen des Stromspeichers zu vermeiden, andererseits, wenn dieser mit unrichtiger Polung in ein Ladegerät eingesetzt wird.

Dieses Problem gilt insbesondere für stabförmige Stromspeicher (Batterien, Monozellen und Ähnliches), die an einem Ende den Pluskontakt und am anderen Ende den negativen Minuskontakt haben.

Aus der US 5,183,712 A ist eine Trockenbatterie bekannt, bei der sowohl der positive als auch der negative Kontakt zur Längsachse der Trockenbatterie rotationssymmetrisch ausgebildet sind. Dies setzt aber (vgl. Fig. 2 der US 5,183,712 A) voraus, dass die Trockenbatterie in eine Batterieaufnahme lagerichtig eingesetzt werden muss.

Aus der US 2006/0275656 A1 ist ein zu seiner Längsmittelebene nicht symmetrischer Stromspeicher bekannt, der einen Kontakt im Bereich seiner Längsmittelebene und zwei weitere Kontakte im Abstand von seiner Längsmittelebene besitzt. Der Stromspeicher besitzt eine langgestreckte Form mit einem runden Querschnitt. Ein negativer Kontakt ist rings um den Stromspeicher herumlaufend ausgebildet. Bei dem aus der US 2006/0275656 A1 bekannten Stromspeicher haben die an seinen Enden angeordneten Kontakte entgegengesetzte Polaritäten. Der im Bereich der Längsmittelebene des Stromspeichers angeordnete Kontakt hat die Polarität eines der an den Enden vorgesehenen Kontakte. Dies bedeutet, dass der Stromspeicher nicht mit beliebiger Ausrichtung in ein Gerät eingesetzt werden kann.

Der Erfindung liegt die Aufgabe zu Grunde, einen Stromspeicher vorzuschlagen, bei dem auf eine richtige Ausrichtung seiner Kontakte nicht mehr geachtet werden muss.

Gelöst wird diese Aufgabe erfindungsgemäß mit einem Stromspeicher, welcher die Merkmale von Anspruch 1 aufweist.

Bevorzugte und vorteilhafte Ausgestaltungen der Erfindung sind Gegenstand der Unteransprüche.

Da bei dem erfindungsgemäßen Stromspeicher die Kontakte bezüglich der Längsmittelebene des Stromspeichers symmetrisch angeordnet sind, ist es gleichgültig, mit welcher Ausrichtung er in ein Gerät eingesetzt wird, das er mit Strom versorgen soll, und es ist auch gleichgültig, in welcher Ausrichtung er in ein Ladegerät eingesetzt wird, wenn es sich um einen (wieder-)aufladbaren Stromspeicher handelt. Mit anderen Worten sind die Kontakte bezüglich der Längsmittelebene des Stromspeichers "gespiegelt".

Die Erfindung kann bei allen Formen von Stromspeichern angewendet werden, ganz unabhängig von der Form des Stromspeichers, der eckig, rund, kurz oder lang sein kann, und insbesondere auch unabhängig von der Querschnittsform des Stromspeichers, die polygonal (viereckig, rechteckig, dreieckig oder auch mehreckig), ebenso rund, sein kann, wie dies für Monozellen ("Batterien") bekannt ist.

Die Erfindung ist für jede Art von Stromspeichern, unabhängig von ihrer Leistung, anwendbar.

Weiters ist bei der Erfindung, unabhängig davon, ob der Stromspeicher ein- oder mehrzellig ist, lediglich wesentlich, dass die Kontakte, über welche der Stromspeicher angeschlossen werden kann, bezüglich der Außenform des Stromspeichers symmetrisch angeordnet sind.

Weiters ist die Erfindung unabhängig davon, welche Bauart eines Stromspeichers verwendet wird, ob es sich um einfache Zink-Kohle-Batterien, Nickel-Kadmium-Batterien, Nickel-Metallhydrid-Batterien, Lithium-Ionen-Batterien, Lithium-Polymer-Batterien ("LiPo-Batterien") oder Ähnliches handelt. Dabei sind im erfindungsgemäßen elektrischen Energiespeicher eine, zwei oder mehrere Einzelzellen vorgesehen.

Bei dem erfindungsgemäßen Stromspeicher sind die Kontakte bezüglich einer Symmetrieebene, die in der Längsmittelebene des Stromspeichers liegt, symmetrisch angeordnet sind. Dabei sind ein Kontakt im Wesentlichen in der Mitte des (langgestreckten) Stromspeichers und zwei weitere Kontakte an den Enden des Stromspeichers vorgesehen. Dabei ist es gleichgültig, ob der Kontakt in der Mitte der Pluskontakt (positiver Kontakt) oder ein Minuskontakt (negativer Kontakt) ist.

Die Konstruktion der Kontakte ist ebenfalls weitestgehend beliebig, sie können mit der Außenfläche des Stromspeichers (seines Gehäuses) bündig, versenkt oder vorstehend ausgebildet sein. Schließlich besteht im Rahmen der Erfindung die Möglichkeit, die Kontakte offen oder abgedeckt auszuführen.

Von Vorteil bei dem erfindungsgemäßen Stromspeicher mit seinen symmetrisch angeordneten Kontakten ist es, dass er quasi "blind" in das Gerät eingesetzt werden kann, ganz gleich, ob der Stromspeicher in einen Verbraucher (als Einzelzelle oder Akku-/Batteriepack) oder für einen Ladevorgang in ein Ladegerät eingesetzt wird.

Im Rahmen der Erfindung kann vorgesehen sein, dass die Kontakte um die Umfangsfläche der Außenform des Gehäuses herumlaufend, also im Wesentlichen ringförmig (kreisrunde Ringe oder polygonale Ringe), angeordnet sind, so dass auch hier eine bessere Stromabnahme (mit "mehrfachen Druck- und/oder Schleif- oder Federkontakten") möglich ist.

Im Rahmen der Erfindung ist auch eine Ausführungsform des Stromspeichers in Betracht gezogen, bei welcher insbesondere in der Längsmittelebene eines, beispielsweise langgestreckt ausgebildeten, Stromspeichers zusätzliche Kontakte (wenigstens ein zusätzlicher Kontakt, vorzugsweise in Form einer "Datenspur") vorgesehen sind, über welche ein in den Stromspeicher integrierter Datenspeicher kontaktiert werden kann. In dem Datenspeicher können Daten betreffend den Stromspeicher, insbesondere dessen Kapazität, Spannung und die Anzahl der (bisherigen) Lade-/Entladezyklen und dgl. gespeichert sein.

Für den erfindungsgemäßen Stromspeicher (elektrischen Energiespeicher) ist es belanglos, ob die symmetrische Anordnung der Kontakte unmittelbar an der elektrischen Zelle oder an einem wenigstens eine elektrische Zelle enthaltenden Gehäuse für diese verwirklicht ist.

Die symmetrische Anordnung von Kontakten bei dem erfindungsgemäßen Stromspeicher kann in vorteilhafter Weise noch dadurch weitergebildet sein, dass jeder Kontakt bezüglich einer Längsachse des Stromspeichers, das ist die Längsachse, die durch die Mitte der vom jeweiligen Kontakt umschriebenen Fläche oder eingenommenen Fläche geht, symmetrisch (z.B. rotationssymmetrisch) ausgebildet ist. In einem speziellen Fall ist dies eine konzentrische Anordnung der Längsachse zu den Kontakten oder einzelnen derselben.

In einer bevorzugten Ausführungsform besitzt der erfindungsgemäße Stromspeicher einen mittig angeordneten, ringsum laufenden und vorzugsweise vertieft ausgebildeten Kontakt (durch die vertiefte Ausbildung ist der Kontakt geschützt) und dazu symmetrisch zwei weitere Kontakte mit zum mittigen Kontakt unterschiedlicher Polung, die beispielsweise an den jeweiligen Endflächen des Stromspeichers angeordnet oder diesen benachbart angeordnet sind.

In einer Ausführungsform der Erfindung ist vorgesehen, dass, um die Kurzschlussgefahr möglichst hintanzuhalten, ein Kontakt mit der Außenfläche plan liegt und der andere Kontakt, der in der gleichen Ebene liegt, vertieft ausgebildet ist.

Wenn bei dem erfindungsgemäßen Stromspeicher eine oder mehrere "Datenspuren", die bevorzugt in der Mitte angeordnet sind, vorgesehen sind, sind sowohl zwei positive Kontakte (Pluspole) als auch zwei negative Kontakte (Minuspole) zur Mittelebene symmetrisch angeordnet.

Wenn im erfindungsgemäßen Stromspeicher eine oder mehrere Zellen angeordnet sind, also die Zellen von einem Gehäuse oder Ähnlichem umgeben sind, wird durch eine innere Verdrahtung der Zellen erreicht, dass diese mit den jeweiligen Polen elektrisch leitend verbunden sind.

Ein Vorteil der erfindungsgemäßen Ausbildung von Stromspeichern (elektrischen Energiespeichern) ist es, dass die Stromspeicher in Verbraucher oder in Aufnahmeräume ("Akkuboxen") quasi "blind" eingesetzt werden können, da eine unrichtige Polung ausgeschlossen ist.

Zusätzlich wird wegen der Möglichkeit, die Kontaktflächen zu vergrößern, die Möglichkeit geschaffen, je Pol mindestens zwei Abnahmestellen durch Kontakte, insbesondere Druck- und/oder Schleif- oder Federkontakte, zu erreichen.

Insbesondere sind die erfindungsgemäßen Stromspeicher für größere Stromspeicher geeignet, da sie ein praktikables und energieeffizientes Austausch-Stromspeichersystem erlauben, da das Wechseln insofern vereinfacht ist, als auf eine richtige Polung beim Neueinsetzen von Austausch-Stromspeichern nicht mehr geachtet werden braucht.

Beispielsweise können die erfindungsgemäßen Stromspeicher eine Leistungseinheit von 1 KWh (400 Volt bei 2,5 Amperestunden) haben.

Im Rahmen der Erfindung ist auch die Möglichkeit gegeben, dass ein Stromspeicher so ausgebildet ist, dass er verdeckte Kontakte aufweist, die durch eine Aktivierung, also wenn der Akku in einem Verbraucher eingesetzt ist, freigegeben und elektrisch kontaktiert werden. Dies gilt auch für das Laden solcher Akkumulatoren wobei hier sichergestellt wird, dass eine optimale sichere Behandlung des Stromspeichers, besonders der Zellen in diesen, gegeben ist, da beispielsweise die Ladung erst dann erfolgt, wenn die hiefür geeigneten Bedingungen gegeben sind. Beispielsweise ist es für bestimmte Akkutypen (LiPos) wichtig, dass der Ladevorgang erst bei einer bestimmten Temperatur vorgenommen wird und nicht bei zu tiefen Temperaturen erfolgt.

In einer beispielsweisen Ausführungsform ist der erfindungsgemäße Stromspeicher dadurch gekennzeichnet, dass der Stromspeicher eine langgestreckte Form besitzt.

In einer beispielsweisen Ausführungsform ist der erfindungsgemäße Stromspeicher dadurch gekennzeichnet, dass der Stromspeicher eine Querschnittsform ausgewählt aus der Gruppe, bestehend aus polygonal, rechteckig, quadratisch, dreieckig, rund und kreisrund, besitzt.

In einer beispielsweisen Ausführungsform ist der erfindungsgemäße Stromspeicher dadurch gekennzeichnet, dass die Kontakte, die im Abstand von der Symmetrieebene angeordnet sind, über die Endflächen des Stromspeichers vorstehen.

In einer beispielsweisen Ausführungsform ist der erfindungsgemäße Stromspeicher dadurch gekennzeichnet, dass die Kontakte, die im Abstand von der Symmetrieebene angeordnet sind, in den Endflächen des Stromspeichers versenkt angeordnet sind.

In einer beispielsweisen Ausführungsform ist der erfindungsgemäße Stromspeicher dadurch gekennzeichnet, dass die im Abstand von der Symmetrieebene angeordneten Kontakte an den Endflächen und/oder den angrenzenden Bereichen der Außenseite des Stromspeichers angeordnet sind.

In einer beispielsweisen Ausführungsform ist der erfindungsgemäße Stromspeicher dadurch gekennzeichnet, dass die Kontakte über die Außenfläche des Stromspeichers vorstehend angeordnet sind.

In einer beispielsweisen Ausführungsform ist der erfindungsgemäße Stromspeicher dadurch gekennzeichnet, dass die Kontakte gegenüber der Außenfläche des Stromspeichers versenkt angeordnet sind.

In einer beispielsweisen Ausführungsform ist der erfindungsgemäße Stromspeicher dadurch gekennzeichnet, dass die Kontakte in der Außenfläche des Stromspeichers liegen.

In einer beispielsweisen Ausführungsform ist der erfindungsgemäße Stromspeicher dadurch gekennzeichnet, dass neben dem Kontakt für den Zugriff auf den Datenspeicher zwei Kontakte des Stromspeichers angeordnet sind.

In einer beispielsweisen Ausführungsform ist der erfindungsgemäße Stromspeicher dadurch gekennzeichnet, dass Kontakte rings um den Stromspeicher herumlaufend ausgebildet sind.

In einer beispielsweisen Ausführungsform ist der erfindungsgemäße Stromspeicher dadurch gekennzeichnet, dass wenigstens der negative Kontakt rings um den Stromspeicher herumlaufend ausgebildet ist.

In einer beispielsweisen Ausführungsform ist der erfindungsgemäße Stromspeicher dadurch gekennzeichnet, dass wenigstens der positive Kontakt rings um den Stromspeicher herumlaufend ausgebildet ist.

In einer beispielsweisen Ausführungsform ist der erfindungsgemäße Stromspeicher dadurch gekennzeichnet, dass der Kontakt für den Zugriff auf den Datenspeicher rings um den Stromspeicher herumlaufend ausgebildet ist.

In einer beispielsweisen Ausführungsform ist der erfindungsgemäße Stromspeicher dadurch gekennzeichnet, dass an den Enden des Stromspeichers vorgesehene Kontakte rings um den Stromspeicher herumlaufend ausgebildet sind.

In einer beispielsweisen Ausführungsform ist der erfindungsgemäße Stromspeicher dadurch gekennzeichnet, dass der wenigstens eine im Bereich der Mitte des Stromspeichers angeordnete Kontakt rings um den Stromspeicher herumlaufend ausgebildet ist

Durch die erfindungsgemäße Ausgestaltung des Stromspeichers sind Konstruktionen möglich, die verschiedene Varianten bezüglich Ausführung der Stromspeicher (Akkudesign) und der dazu gehörigen Akkuboxen geben. Dies ist für Reihen- wie auch für Parallelschaltungen, abhängig von dem jeweiligen Verwendungszweck (Elektroscooter, Elektroautos, Elektroboote, aber auch Pufferspeicher) von Vorteil.

Weitere Einzelheiten, Vorteile und Merkmale der Erfindung ergeben sich aus der nachstehenden Beschreibung von Ausführungsbeispielen anhand der schematischen Zeichnungen.

Es zeigt:
- Fig. 1: in Seitenansicht eine einfache Ausführungsform eines erfindungsgemäßen Stromspeichers,
- Fig. 2: einen Stromspeicher in Schrägansicht,
- Fig. 3: eine weitere Ausführungsform eines Stromspeichers,
- Fig. 4: eine andere Ausführungsform eines Stromspeichers,
- Fig. 5: eine weitere Ausführungsform eines Stromspeichers,
- Fig. 6 und 7: zwei weitere Ausführungsformen von erfindungsgemäßen Stromspeichern,
- Fig. 8: eine mögliche Ausführungsform einer Anordnung zum Aufnehmen erfindungsgemäßer Stromspeicher,
- Fig. 9: eine weitere Ausführungsform einer solchen Anordnung,
- Fig. 10: in Schrägansicht eine einfache Ausführungsform eines erfindungsgemäßen Stromspeichers mit dargestellter Symmetrieebene und ebenfalls eingezeichneter Mittelachse,
- Fig. 11: im Schnitt eine Ausführungsform eines erfindungsgemäßen Stromspeichers mit einer Zelle,
- Fig. 12: im Schnitt einen erfindungsgemäßen Stromspeicher mit mehreren (drei) Zellen,
- Fig. 13: eine Schaltung zur Aufnahme von drei erfindungsgemäßen Stromspeichern in einer Akku-Box,
- Fig. 14: ist eine Schnittzeichnung der Akku-Box vom Fig. 13 zur Verdeutlichung doppelt ausführbarer Kontakte bei Boxenhalterungen und sonstigen Kontaktschienen für erfindungsgemäße Stromspeicher,
- Fig. 15: in Schrägansicht eine weitere Ausführungsform eines erfindungsgemäßen Stromspeichers,
- Fig. 16: eine weitere Ausführungsform eines erfindungsgemäßen Stromspeichers,
- Fig. 17: eine Ausführungsform eines erfindungsgemäßen Stromspeichers mit Datenspuren und umlaufenden, vertieften Polkontakten,
- Fig. 18: eine weitere Ausführungsform,
- Fig. 19: die Ausführungsform von Fig. 18 in anderer Ansicht,
- Fig. 20: eine Ansicht der Abschlussscheiben mit Abdeckung des Stromspeichers von Fig. 18,
- Fig. 21: eine Variante der Abdeckung,
- Fig. 22: einen Stromspeicher mit teilweiser Außenhülle und
- Fig. 23 bis 25: Varianten des Stromspeichers mit teilweise weggebrochener Außenhülle.

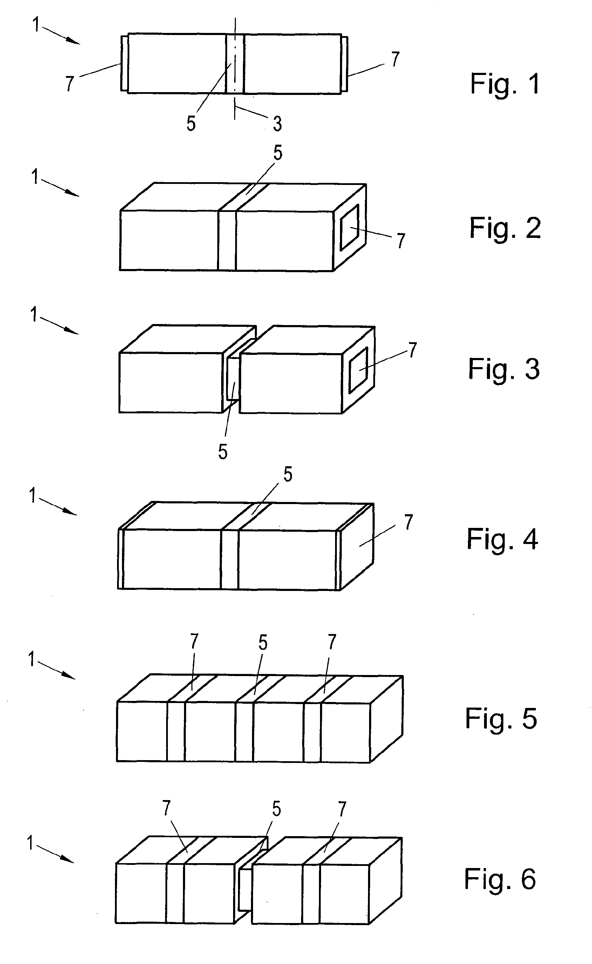

Ein in Fig. 1 und 2 gezeigter Stromspeicher 1 ist langgestreckt ausgeführt und hat im gezeigten Ausführungsbeispiel eine im Wesentlichen quadratische Querschnittsform. Dabei ist zu beachten, dass jede andere Querschnittsform (eckig oder rund) ebenso in Betracht gezogen ist. Der Stromspeicher 1 besitzt eine Längsmittelebene (Symmetrieebene) 3.

Ein Kontakt 5, beispielsweise der positive Kontakt, ist in der Längsmitte des Stromspeichers 1, also im Bereich der Längsmittelebene 3, angeordnet und beispielsweise rings um die Umfangsfläche des Stromspeichers 1 verlaufend ausgebildet (ringförmig). An beiden Enden des Stromspeichers 1 sind zwei weitere Kontakte 7 symmetrisch zur Längsmittelebene 3 angeordnet. Die Kontakte 7 sind im gezeigten Ausführungsbeispiel negative Kontakte.

Dabei ist in Betracht gezogen, dass auch Ausführungsformen im Rahmen der Erfindung gewählt werden können, bei welchen der negative Kontakt der Kontakt 5 ist und die positiven Kontakte die Kontakte 7 an den Enden des Stromspeichers 1 sind.

Bei der in Fig. 1 gezeigten Ausführungsform sind die an den Enden des Stromspeichers 1 vorgesehenen Kontakte 7 als über die Endflächen vorstehende Kontakte ausgebildet.

Bei der in Fig. 2 gezeigten Ausführungsform eines Stromspeichers 1 sind die Kontakte 7 mit den Endflächen des Stromspeichers 1 bündig ausgebildet, wobei im Rahmen der Erfindung auch in Betracht gezogen ist, dass die Kontakte 7 gegenüber den Endflächen des Stromspeichers 1 versenkt ausgebildet sind.

Bei der in Fig. 3 gezeigten Ausführungsform eines erfindungsgemäßen Stromspeichers 1 ist der im Bereich der Längsmittelebene 3 vorgesehene Kontakt 5, der sich rings um den Stromspeicher 1 herum erstrecken kann, gegenüber den Außenflächen des Stromspeichers 1 versenkt angeordnet (liegt also in einer Nut). Bei der in Fig. 3 gezeigten Ausführungsform sind die an den Enden des Stromspeichers 1 vorgesehenen Kontakte 7 mit den Endflächen bündig oder versenkt.

Bei der in Fig. 4 gezeigten Ausführungsform sind die Kontakte 7, die an den Enden des Stromspeichers 1 vorgesehen sind, ringförmig ausgebildet und erstrecken sich so, wie der Kontakt 5, rings um die Außenfläche des Stromspeichers 1. Die Kontakte 5 und/oder 7 können ähnlich wie der Kontakt 5 von Fig. 3 gegenüber der Außenfläche des Stromspeichers 1 zurückversetzt (also in "Nuten") vorgesehen sein.

Dabei ist eine Ausführungsform (nicht gezeigt) in Betracht gezogen, bei welcher auch die Kontakte 7 der Ausführungsform von Fig. 4 sowie der Kontakt 5 von Fig. 3 gegenüber der Außenfläche versenkt angeordnet sind.

Fig. 5 zeigt eine weitere Ausführungsform, bei welcher die Kontakte 7 zur Längsmittelebene 3 symmetrisch angeordnet, jedoch von den Endflächen des Stromspeichers 1 zur Mitte (Längsmittelebene) 3 hin versetzt angeordnet sind. Auch bei der in Fig. 5 gezeigten Ausführungsform können die Kontakte 7 und/oder die Kontakte 5 gegenüber der Außenfläche des Stromspeichers 1 versenkt angeordnet sein, wie dies für den Kontakt 5 in Fig. 3 gezeigt ist. So zeigt beispielsweise die Fig. 6 eine Ausführungsform, bei welcher ausgehend von Fig. 5 der mittige Kontakt 5 gegenüber der Außenfläche des Stromspeichers 1 versenkt angeordnet ist.

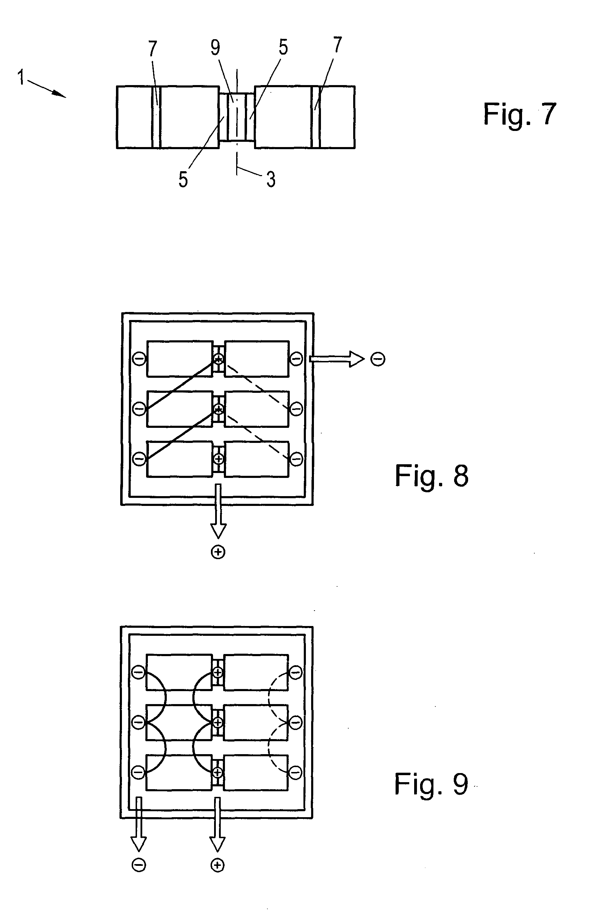

Die in Fig. 7 gezeigte Ausführungsform eines erfindungsgemäßen Stromspeichers 1 besitzt zur Längsmittelebene 3 symmetrisch angeordnete Kontakte 5 und ebenfalls symmetrisch angeordnete Kontakte 7, wobei die Kontakte 7 bei dieser Ausführungsform gegenüber den Enden des Stromspeichers 1 zur Längsmittelebene 3 hin versetzt angeordnet sind. Die Kontakte 7 können aber auch an den Enden ausgebildet sein und eine Ausführungsform besitzen, wie sie in den Fig. 1, 2 oder 4 gezeigt ist.

Bei der in Fig. 7 gezeigten Ausführungsform ist in dem Stromspeicher 1 ein Datenspeicher angeordnet, der über wenigstens einen Kontakt 9 ("Datenspur") kontaktiert werden kann. Dabei ist in der in Fig. 7 gezeigten Ausführungsform die Anordnung so gewählt, dass seitlich neben dem Kontakt 9 für den Datenspeicher zwei Kontakte 5 vorgesehen sind, die symmetrisch zur Längsmittelebene 3 angeordnet sind. Wenn dem Datenspeicher mehr als ein Kontakt 9 zugeordnet ist, können diese zur Längsmittelebene 3 symmetrisch angeordnet sein.

Ein Datenspeicher kann auch bei den anderen Ausführungsformen der Erfindung (z.B. jenen der Fig. 1 bis 6 und Fig. 10 sowie Fig. 15 bis 17) verwirklicht sein.

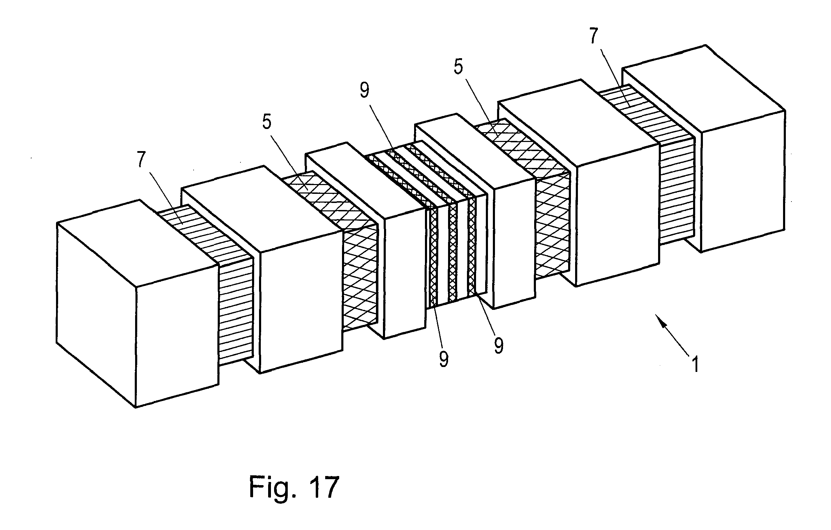

Es ist darauf hinzuweisen, dass in jeder der in den Zeichnungen gezeigten Ausführungsformen eine Abwandlung dahingehend getroffen werden kann, dass nicht nur ein Kontakt 5 vorgesehen ist, sondern ähnlich wie in Fig. 7 oder Fig. 17 gezeigt zwei Kontakte 5 vorgesehen sind, die zur Längsmittelebene 3 des Stromspeichers 1 symmetrisch angeordnet sind, also von dieser Ebene gleiche Abstände aufweisen.

In den Fig. 8 und 9 sind Geräte für die Aufnahme mehrerer erfindungsgemäßer Stromspeicher 1 dargestellt. Dabei ist die in Fig. 8 gezeigte Ausführungsform so gestaltet, dass die Stromspeicher 1 in Reihe geschaltet sind, um die Spannung zu erhöhen.

Bei der in Fig. 9 gezeigten Ausführungsform ist die Schaltung so gewählt, dass die Stromspeicher 1 parallel geschaltet sind, so dass sich die Kapazität erhöht.

Allen bisher beschriebenen Varianten (Ausführungsformen) eines erfindungsgemäßen Stromspeichers und auch den nachstehend noch weiters beschriebenen Stromspeichern ist gemeinsam, dass sie ohne lose bzw. heraushängende Kabel oder Laschen zur elektrischen Kontaktierung das Auslangen finden können.

Es besteht die Möglichkeit, die erfindungsgemäßen Stromspeicher im Verbraucher direkt oder über Akkuboxen (Aufnahmeräume) oder sonstige Halterungen mit Verbrauchern und/oder Ladegeräten einfach über Druckkontakte oder Schleifkontakte zu verbinden.

Die Vorteile der erfindungsgemäßen Stromspeicher und die symmetrische Anordnung von Kontakten der erfindungsgemäßen Stromspeicher machen diese besonders für den schnellen und sicheren Einsatz im Wechselbetrieb von elektrischen Stromspeichern geeignet. Dies insbesondere auch, wenn in einem erfindungsgemäßen Stromspeicher mehr als eine Zelle, beispielsweise zwei, drei oder mehr Zellen enthalten und innen fix verdrahtet sind.

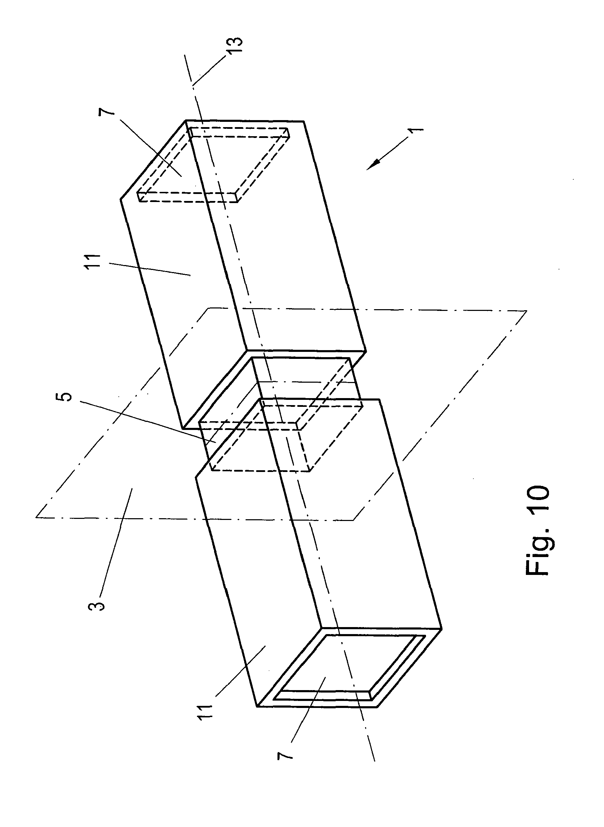

Die in Fig. 10 gezeigte Ausführungsform eines erfindungsgemäßen Stromspeichers 1 besitzt eine Längsmittelebene (Symmetrieebene) 3 und weist eine Längsachse 13 auf. In dem in Fig. 10 gezeigten Ausführungsbeispiel besitzt der erfindungsgemäße Stromspeicher eine im Wesentlichen quadratische Querschnittsform, wobei - wie erwähnt - auch andere Querschnittsformen (eckig, rund oder mit abgerundeten Kanten) ebenso in Betracht gezogen sind.

Ein Kontakt 5, beispielsweise der positive Kontakt, ist in der Längsmitte des Stromspeichers 1, also im Bereich der Längsmittelebene 3 und zu dieser symmetrisch angeordnet. Im gezeigten Ausführungsbeispiel ist der Kontakt 5 ringförmig ausgebildet und gegenüber der Außenfläche des Stromspeichers 1 versenkt ausgebildet, liegt also ringförmig in einer Nut. An den beiden Enden des Stromspeichers 1 ebenso symmetrisch zur Längsmittelebene 3 und auch symmetrisch zu dem Kontakt 5 sind die anderen Kontakte, im Beispiel die negativen Kontakte 7, vorgesehen. Diese sind im Inneren des elektrischen Stromspeichers 1 miteinander verbunden und außen eben zweifach angeordnet.

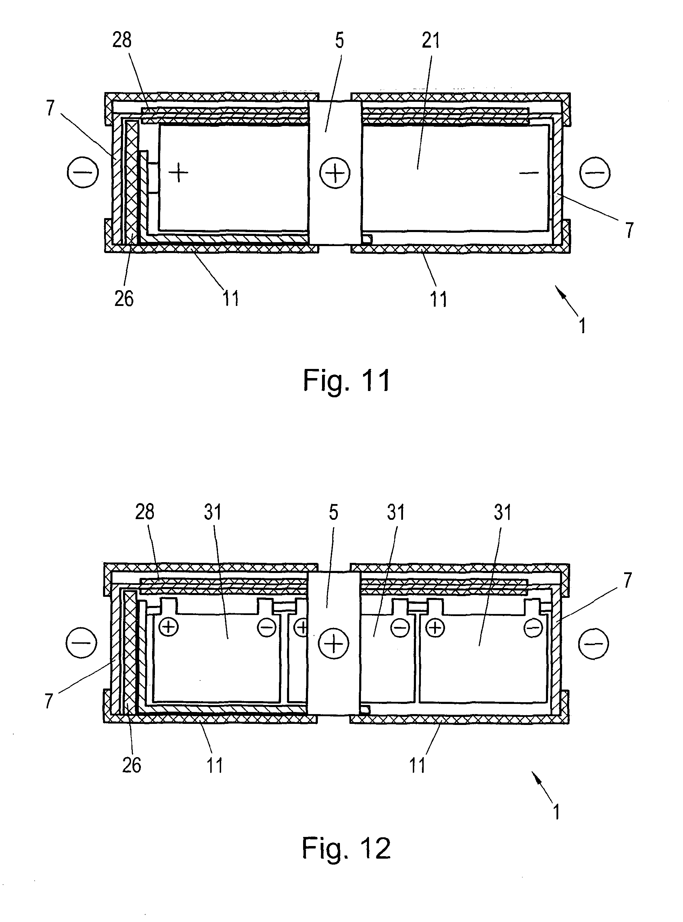

In der Schnittansicht von Fig. 11 ist gezeigt, wie ein erfindungsgemäßer Stromspeicher 1 mit einer einzigen, innen angeordneten Monozelle 21 (z.B. einer NiMH-Zelle) ausgebildet sein kann.

Fig. 12 zeigt schematisch und ebenfalls im Schnitt das Innenleben eines elektrischen Stromspeichers 1 gemäß der Erfindung mit drei Einzelzellen 31 in Reihenschaltung (z.B. LiPos) zur Erhöhung der Spannung. Dabei sind Innenisolationseinlagen 26 und 28 und eine isolierende Hülle 11 nach außen vorgesehen.

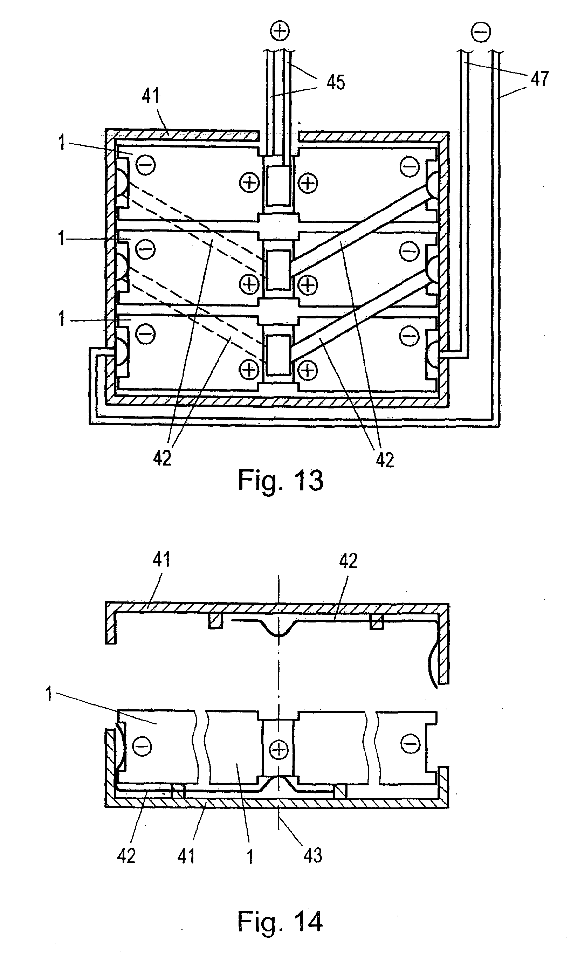

Fig. 13 zeigt schematisch und in Draufsicht und Fig. 14 dazu schematisch im Schnitt als Beispiel eine Box 41 ("Akku-Box") für eine Reihenschaltung von drei erfindungsgemäßen Stromspeichern 1 mit der Ausführungsform von Fig. 10. Dabei sind die Federkontakte 42 sowohl in Fig. 13 als auch in Fig. 14 doppelt ausgeführt und zeigen so die optimale Möglichkeit der Kontaktierung mit den positiven und negativen Kontakten eines erfindungsgemäßen Stromspeichers 1.

In Fig. 13 ist auch gezeigt, dass die Kabel 45 und 47 in doppelter Ausführung aus der Box 41 herausgeführt sein können.

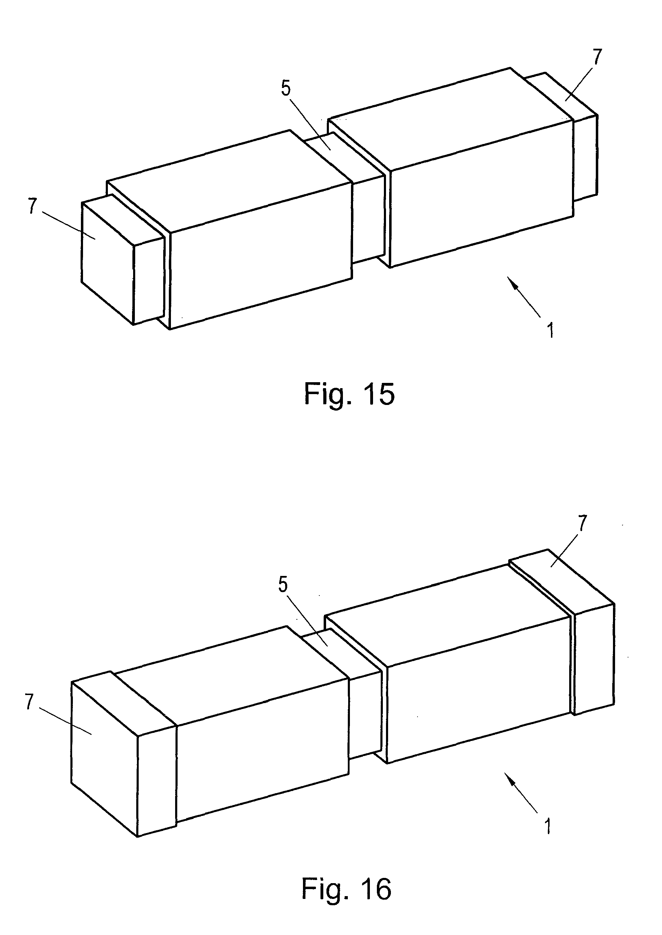

Fig. 14 zeigt zusätzlich, dass die Box aus zwei um die Achse 43 konzentrisch symmetrischen (gespiegelt und dann um 180° gedrehten) Halbschalen bestehen kann. Dieses Ausführungsbeispiel zeigt, dass einfache Boxen und Halterungen für die anderen Varianten der erfindungsgemäßen Stromspeicher, beispielsweise jenen, die in den Fig. 15 bis 17 gezeigt sind, möglich sind.

Bei der in Fig. 10 gezeigten Ausführungsform sind die an den Endflächen des Stromspeichers 1 vorgesehenen (negativen) Kontakte 7 gegenüber den Endflächen versenkt ausgebildet.

Die Ummantelung des Stromspeichers 1 von Fig. 10 kann aus einem (beliebigen) elektrisch isolierenden Werkstoff bestehen und entweder in einem Stück ausgeführt, oder aus mehreren Teilen zusammengesetzt sein, die dann miteinander verbunden sind. Die Verbindung der Teile kann durch Verkleben oder durch Verschrauben erfolgen.

Bevorzugt ist eine Anordnung, wo der positive Kontakt in der Mitte und die negativen Kontakte 7 symmetrisch zur Längsmitte 3 und mit Abstand von dieser ausgeführt sind. In Betracht gezogen ist freilich auch eine Ausführungsform, bei welcher der negative Kontakt in der Mitte ist und die positiven Kontakte an den Enden des elektrischen Stromspeichers 1 vorgesehen sind.

Bei der in Fig. 15 gezeigten Ausführungsform eines elektrischen Stromspeichers sind die Kontakte 7 an den Enden des elektrischen Stromspeichers 1 kappenförmig und über die Endflächen des Stromspeichers 1 vorstehend ausgebildet.

Diese Ausführungsform ist insbesondere, aber nicht ausschließlich, dazu ausgelegt, dass der erfindungsgemäße Stromspeicher über seine Kontakte 7 in V-förmige Gegenkontakte eingesteckt wird und mittels einer innen leitenden, außen isolierten Schelle über den Kontakt 5 nach unten fixiert werden kann. Die in Fig. 15 gezeigte, vertiefte Ausführungsform der Kontakte 7 ist nicht zwingend, sondern die Seitenflächen der Kontakte 7 können auch mit den Außenflächen des elektrischen Stromspeichers plan (fluchtend) ausgerichtet sein.

Bei der in Fig. 16 gezeigten Ausführungsform eines erfindungsgemäßen Stromspeichers 1 sind die Kontakte 7 ähnlich wie in Fig. 15 kappenförmig ausgebildet, jedoch mit über die Außenflächen des Stromspeichers 1 vorstehenden Seitenflächen ausgebildet.

Bei der in Fig. 17 gezeigten Ausführungsform eines erfindungsgemäßen Stromspeichers 1 gelten die weiter oben für die anderen Ausführungsformen erläuterten Grundsätze. Die in Fig. 17 gezeigte Ausführungsform zeichnet sich dadurch aus, dass mehrere Datenspuren 9 (es können eine, zwei oder mehrere Datenspuren 9 vorgesehen sein) für die Kommunikation zwischen dem erfindungsgemäßen Stromspeicher 1 mit weiteren elektrischen oder elektronischen Bauteilen vorgesehen sind. Die symmetrisch angeordneten Kontakte 5 und 7 sind hier beide jeweils doppelt ausgeführt und zur Längsmittelebene 3 symmetrisch angeordnet.

Die in der Fig. 17 gezeigte Ausführungsvariante hat den Vorteil, dass die positiven und negativen Kontakte unabhängig von der effektiven Länge des elektrischen Stromspeichers 1 immer gleiche Abstände von der Längsmittelebene 3 haben können.

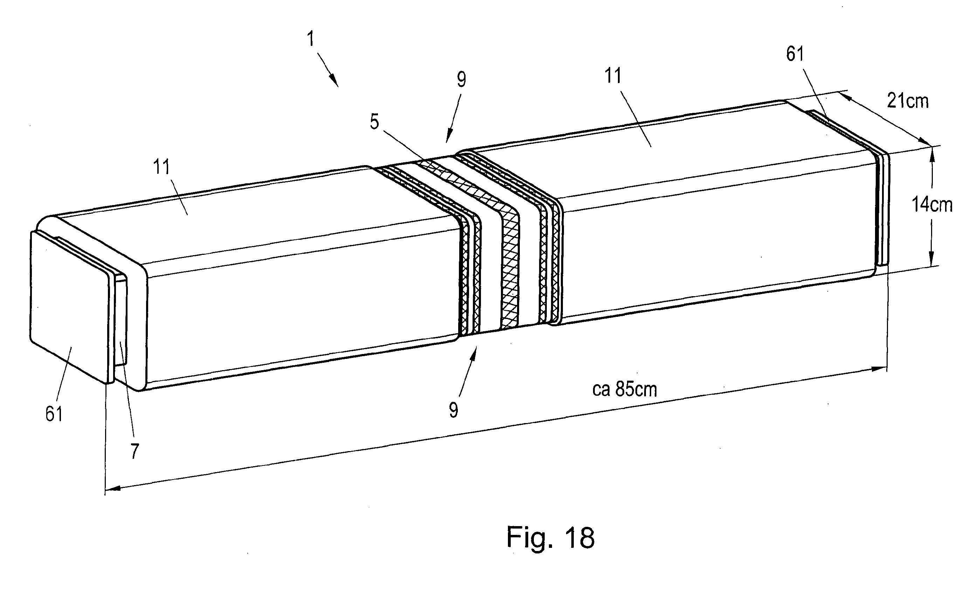

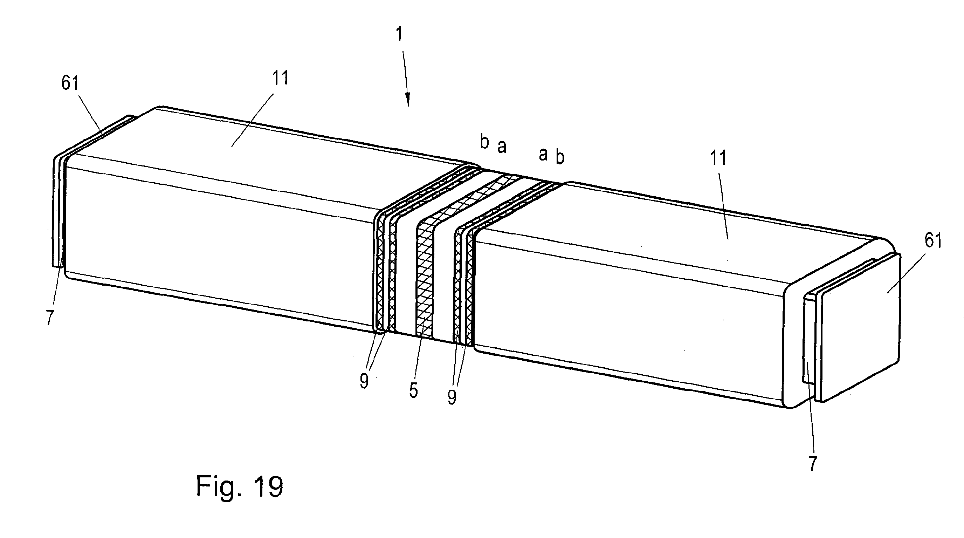

Die Fig. 18 und 19 zeigen eine Ausführungsform des Stromspeichers 1, die als Schnellwechselakku ausgebildet ist. Im Beispiel hat der Stromspeicher 1 eine Gesamtlänge von ca. 85 cm und einen rechteckigen Querschnitt im Seitenverhältnis von 2:3, beispielsweise 14 cm x 21 cm.

Der Stromspeicher 1, z.B. mit der in Fig. 18 und 19 gezeigten Ausführungsform, hat eine definierte, einheitliche, nominale Ausgangsspannung von z.B. 400V und eine je nach Technik bzw. Anforderung/Akkutyp variable Gesamtleistung. So ist der Stromspeicher 1 beispielsweise zumindest für eine Leistung von jeweils 2 KWh oder mehr, bei einem geplanten Maximalgewicht von ca. 25 kg ausgelegt.

Der den Pluspol bildende Kontakt 5 ist mittig umlaufend in der Symmetrieebene angeordnet. Die beiden Kontakte 9 für Datenübermittlung ("Datenspuren") sind ebenfalls umlaufend und von der Mitte aus symmetrisch bzw. doppelt/gespiegelt (ba ab) angeordnet. Über diese Kontakte 9 werden Informationen (Identifikation, Akkutyp, Belastbarkeit bzw. diverse Zustände, Anforderung von Warm- oder Kaltluft etc.) für die Optimierung des Fahrbetriebes (aber auch beim internen Ladevorgang, z.B. in einem Raum ("Akku-Box") für die Aufnahme von Stromspeichern in einem Elektroauto), bevorzugt mit einer der "Akku-Box" zugeordneten Elektronik ("Box-Elektronik") und/oder der zentralen Fahr- und Steuerelektronik eines Elektrofahrzeuges, ausgetauscht. Weiters können über diese Datenspuren 9 (alternativ zu einer Induktions- oder Magnetlösung) die Stromkontakte von Stromspeichern 1, die in der "Akku-Box" im Fahrzeug vorhanden sind, von der "Box-Elektronik" selektiv elektrisch aktiviert/deaktiviert werden. Weiters können betriebsrelevante Daten für eine etwaige Benutzungsverrechnung nach Zeit, Kapazitätsverbrauch, Ladezyklen, etc. und Daten für die Akkupflege (interne und externe Spitzenwerte bei Ladung/Betrieb etc.) oder aber auch z.B. Informationen für den notwendigen Austausch einzelner schadhafter Zellen im Stromspeicher 1 bereitgestellt werden.

Das Mittelstück mit den Kontakten 5 und 9 ist gegenüber der geteilten Außenhülle 11 des Stromspeichers 1 vertieft. Der Kontakt 7 (z.B. der Minuspol) ist doppelt ausgeführt und symmetrisch, umlaufend und deutlich versenkt zwischen den Außenflächen in der Längsachse und den Abschlussscheiben 61 angeordnet.

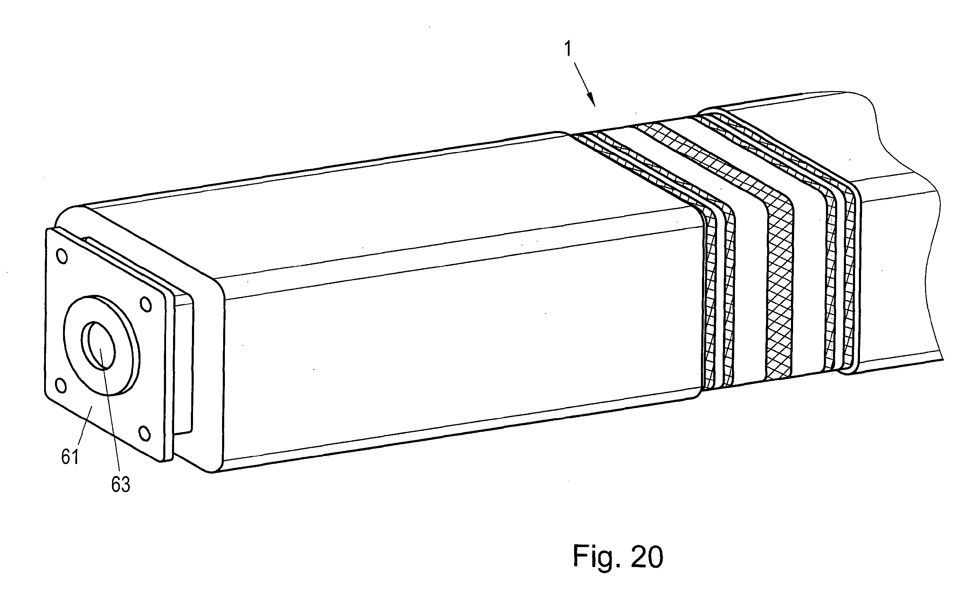

Figur 20 zeigt einen Stromspeicher 1 mit einer Abschlussscheibe 61, die gleichzeitig als Führung in einer entsprechenden Nut einer Akkubox beim Ein- bzw. Ausbringen des Stromspeichers dient, und eine bewegliche Abdeckung 63, die den Stromspeicher 1 von innen hermetisch verschließt.

In Betracht gezogen ist, dass über jeweils zwei Arretierungsbolzen links und rechts als Teile der Akkubox die Abdeckungen 63 in den Stromspeicher 1 hinein gedrückt werden, wobei dieser somit einerseits in der Akkubox sicher in der richtigen Lage gehalten wird, und andererseits gleichzeitig über einen dahinter befindlichen Druckschalter eine zweite Aktivierungsstufe (zweite Sicherheitsstufe) eingeschalten werden kann.

Durch die dabei entstehenden zwei Öffnungen im Stromspeicher 1 kann je nach Bedarf warme oder kalte Luft über die Akkubox bzw. genauer durch seitliche Löcher in hohlen Arretierungsbolzen in den Stromspeicher 1 eingeblasen werden.

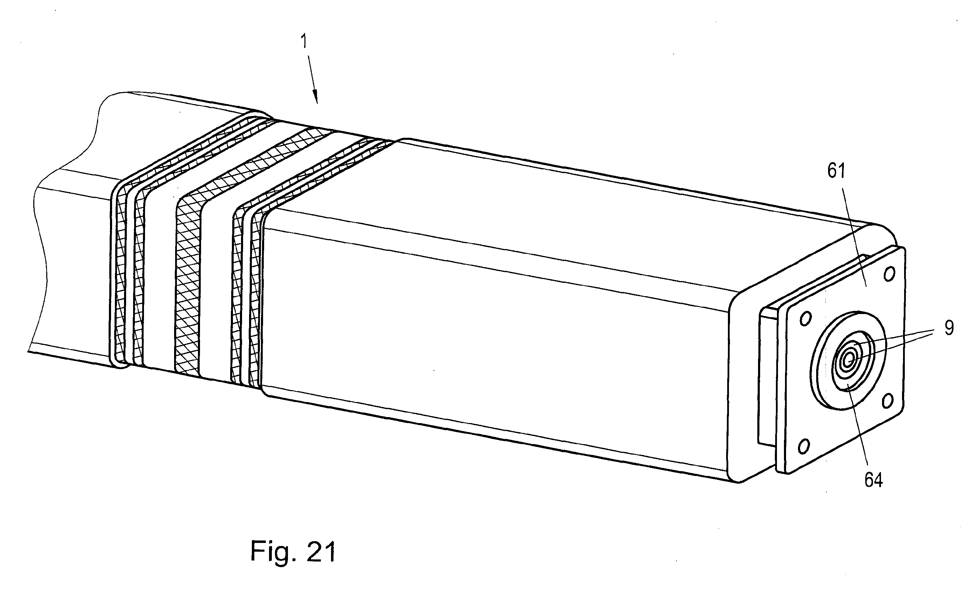

Figur 21 zeigt eine alternative Ausführungsform des Stromspeichers 1, bei dem die Datenspuren 9 statt in der Mitte, in Form von konzentrischen Kontaktkreisen jeweils außen in zwei Abdeckungen 64 integriert sind. Somit entsteht beim Festlegen des Stromspeichers 1 in einem Aufnahmeraum einer Akkubox selbsttätig eine Verbindung mit Kontakten an den Stirnseiten der Arretierungsbolzen.

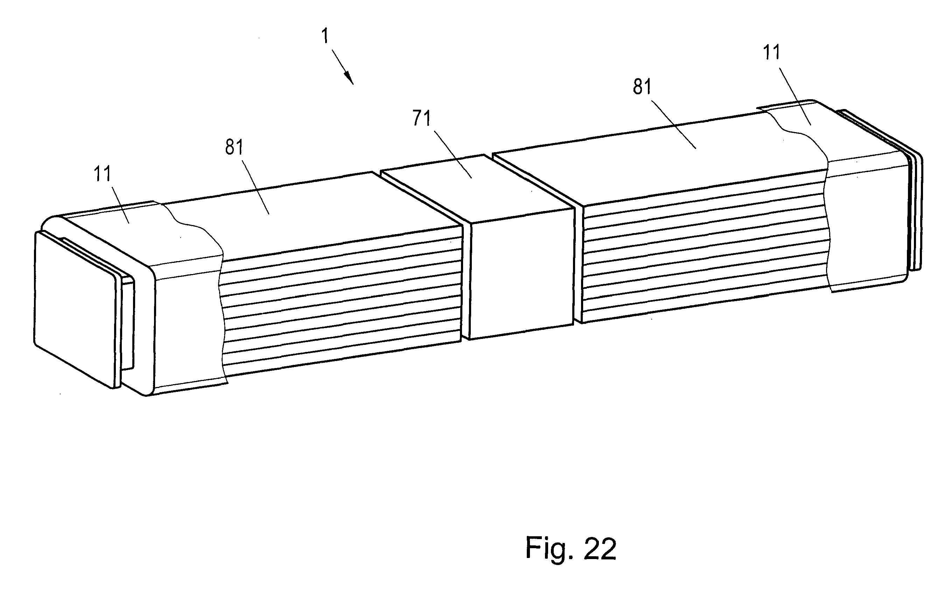

Figur 22 zeigt einen Stromspeicher 1 ohne Darstellung des/der Mittelkontakte und mit teilweise aufgeschnittenen Außenhüllen 11. Erkennbar ist eine mögliche Anordnung von zwei Komponenten, nämlich zwei Zellenblöcken 81 beidseits von einer auf Typ und Anzahl der jeweiligen Zellen abgestimmten, zentralen, elektronischen Kontrolleinheit 71 im Inneren des Stromspeichers 1.

Die Zellenblöcke 81 bestehen in dieser Ausführungsform aus jeweils zehn Lithium-Polymer (LiPo)-Zellen, z.B. in einer Größe von Zellen für Elektroautos (ca. 1cm dicke Platten, ca. im A4-Format und mit beiden Polen auf einer der kurzen Seiten) und geben daher bei einem Verbund in Serienschaltung 2 x 37V = 74V Nominalspannung ab. Zum Erreichen der geforderten einheitlichen Nominalspannung von 400V kann ein DC/DC-Wandler eingesetzt werden.

In der zentralen elektronischen Kontrolleinheit 71 ist u.a. der (optional induktive) Wahlschalter für die Funktion der Kontakte 5 und/oder 7 (welche Funktion auf "Inaktiv od. Aktiv=Ausgang bzw. Laden=Eingang" gelegt sein kann), das passende Ladegerät, ein Balancer/Equalizer, bevorzugt ausgelegt für das "stromlose Balancen" - also unabhängig vom Ladevorgang -, der oben erwähnte DC/DC-Wandler, Diagnosegeräte und Sicherungen für die Zellen und das Gesamtklima im Stromspeicher 1 und vorzugsweise ein Datenspeicher für beispielsweise den Zustand und die Nutzung der Zellen.

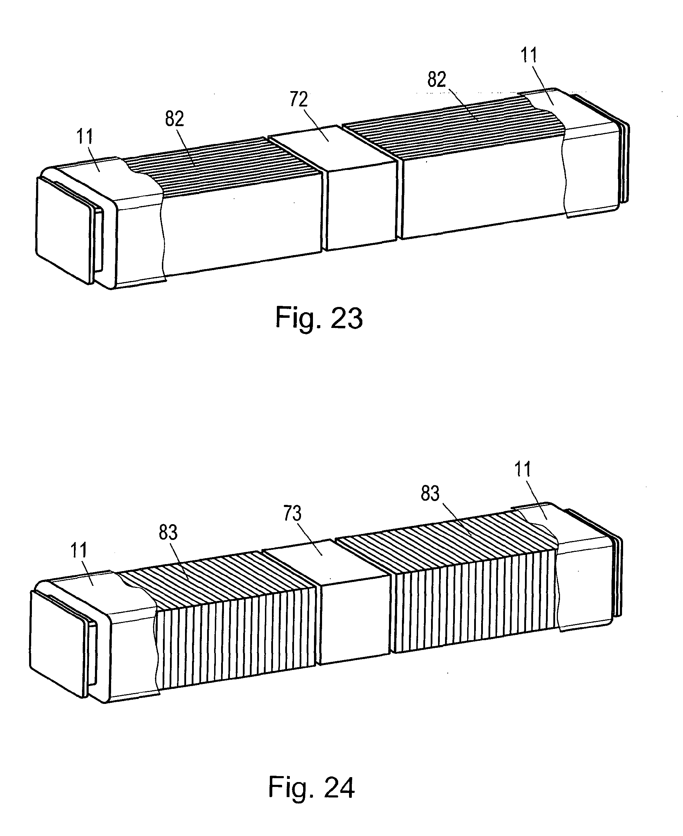

Figur 23 und 24 zeigen in einer Darstellung wie Figur 22 bei unveränderter Außenform und unveränderten Außenmaßen zwei Varianten der Zellenform mit geänderter Zellenzahl im Inneren. Daraus resultieren andere Gesamtspannungen in den Akkublöcken 82 und 83 und geänderte Anforderungen an die zentralen elektronischen Kontrolleinheiten 72 und 73, insbesondere hinsichtlich des Ladegerätes, Balancers und DC/DC-Wandlers. Die Anwendbarkeit/Verwendung in den Aufnahmebereichen einer intelligenten Akkubox in einem Elektroauto bleibt jedoch durch die normierte (geforderte) Bereitstellung von 400V je Stromspeicher 1 dieser Bauart auch bei einer allenfalls geänderten Gesamtleistung uneingeschränkt erhalten.

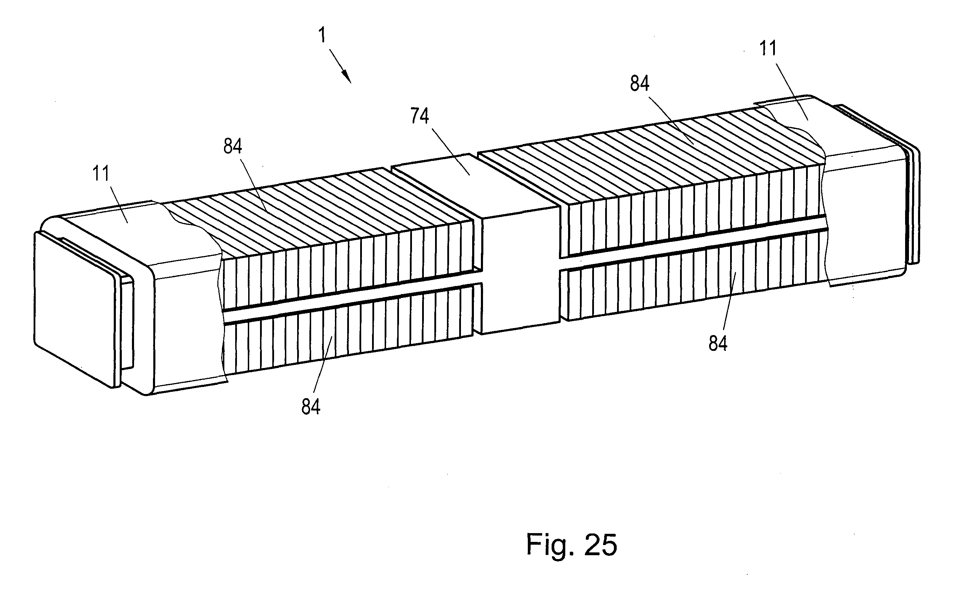

Figur 25 zeigt in einer Darstellungsform wie Figur 22 bei unveränderter Außenform und unveränderten Außenmaßen eine weitere Variante auf Basis der LiPo-Zellenform mit - auf den Schmalseiten der quaderförmigen Einzelzellen 1 - gegenüberliegenden Polkontakten. Bei dieser Ausführungsform eines Stromspeichers 1 sind jeweils 27 Zellen á 3,7V / 5Ah in Serie zu einem Zellenblock 84 zusammengefasst, was bei vier Blöcken eine Gesamtspannung von nominal 400V (genau 399,6V !) ergibt. Das ergibt also auch ohne DC/DC-Wandler die geforderten 400V Ausgangsspannung und bei einer Kapazität von 5Ah je LiPo-Zelle eine Leistung von 2KWh je Stromspeicher. Die auf diese Ausführungsform abgestimmte zentrale elektronische Kontrolleinheit 74 ist so ausgelegt, dass das Ladegerät (die Ladeplatine), insbesondere aber die Balancereinheit beidseits eines zentralen Moduls zwischen je zwei Zellenblöcken angeordnet ist. Diese Tatsache und die spezielle Anordnung der Pole der LiPo-Zellen ermöglicht einen sehr einfachen Gesamtaufbau (insbesondere können für den Balancer die Kabel zu den Einzelzellen direkt in die Platine integriert sein, und die Befestigung der Zellen direkt auf der verstärkten Platine gleichzeitig mit der Verbindung der Zellen in Serie verwirklicht werden). Dieser einfache, gut zugängliche Aufbau erleichtert auch das Service bzw. den Austausch schadhafter Zellen. Vor allem aber bietet dieser "luftige Aufbau" - die Zellenblöcke 84 sind so angeordnet, dass sie von Luft allseitig umströmt werden können - auch optimale Möglichkeiten, um mit - von links bzw. rechts - eingeblasener Warm- oder Kaltluft (vgl. Beschreibung zu Figur 20) dem Stromspeicher 1 optimale Arbeitsbedingungen zu schaffen, ohne dass im Stromspeicher 1 selbst bewegliche Teile wie z.B. Ventilatoren vorhanden sein müssen.

### Zusammenfassend kann ein Ausführungsbeispiel der Erfindung wie folgt beschrieben werden:

Ein Stromspeicher 1 besitzt wenigstens drei Kontakte 5 und 7, wobei die Kontakte 5 und 7 teilweise positive Kontakte 5 und teilweise negative Kontakte 7 sind. Die Kontakte 5 und 7 sind bezüglich der Außenform des Stromspeichers 1, insbesondere bezüglich einer Längsmittelebene 3 desselben, symmetrisch angeordnet. Auf diese Weise kann der Stromspeicher 1 in beliebiger Ausrichtung in ein Gerät (Verbraucher- oder Ladegerät) eingesetzt werden, ohne dass die Gefahr besteht, dass der Stromspeicher 1 mit unrichtiger Polung angeschlossen wird.

## Patentansprüche

1. Stromspeicher (1), der eine langgestreckte Form besitzt und wenigstens einen positiven und wenigstens einen negativen Kontakt (5, 7) aufweist, wobei die Kontakte (5, 7) bezüglich der Außenform des Stromspeichers (1) symmetrisch angeordnet sind, **dadurch gekennzeichnet, dass** die positiven und negativen Kontakte (5, 7) bezüglich der Längsmittelebene (3) des Stromspeichers (1) als Symmetrieebene symmetrisch angeordnet sind und dass wenigstens ein Kontakt (5) im Bereich der Symmetrieebene (3) und zwei weitere Kontakte (7) im Abstand von der Symmetrieebene (3) angeordnet sind.

2. Stromspeicher nach Anspruch 1, **dadurch gekennzeichnet, dass** der Stromspeicher (1) eine Querschnittsform ausgewählt aus der Gruppe, bestehend aus polygonal, rechteckig, quadratisch, dreieckig, rund und kreisrund, besitzt.

3. Stromspeicher nach Anspruch 1 oder 2, **dadurch gekennzeichnet, dass** die Kontakte (7), die im Abstand von der Symmetrieebene (3) angeordnet sind, über die Endflächen des Stromspeichers (1) vorstehen.

4. Stromspeicher nach Anspruch 1 oder 2, **dadurch gekennzeichnet, dass** die Kontakte (7), die im Abstand von der Symmetrieebene (3) angeordnet sind, in den Endflächen des Stromspeichers (1) versenkt angeordnet sind.

5. Stromspeicher nach einem der Ansprüche 1 bis 3, **dadurch gekennzeichnet, dass** die im Abstand von der Symmetrieebene (3) angeordneten Kontakte (7) an den Endflächen und/oder den angrenzenden Bereichen der Außenseite des Stromspeichers (1) angeordnet sind.

6. Stromspeicher nach Anspruch 1 oder 2, **dadurch gekennzeichnet, dass** die Kontakte (5, 7) über die Außenfläche des Stromspeichers (1) vorstehend angeordnet sind.

7. Stromspeicher nach einem der Ansprüche 1 bis 3, **dadurch gekennzeichnet, dass** die Kontakte (5, 7) gegenüber der Außenfläche des Stromspeichers (1) versenkt angeordnet sind.

8. Stromspeicher nach Anspruch 1 oder 2, **dadurch gekennzeichnet, dass** die Kontakte (5, 7) in der Außenfläche des Stromspeichers (1) liegen.

9. Stromspeicher nach einem der Ansprüche 1 bis 8, **dadurch gekennzeichnet, dass** im Bereich der Symmetrieebene (3) des Stromspeichers (1) wenigstens ein weiterer Kontakt (9) für den Zugriff auf einen im Stromspeicher (1) angeordneten Datenspeicher angeordnet ist, welcher Kontakt (9) vorzugsweise rings um den Stromspeicher (1) herumlaufend ausgebildet ist.

10. Stromspeicher nach Anspruch 9, **dadurch gekennzeichnet, dass** neben dem Kontakt (9) für den Zugriff auf den Datenspeicher zwei Kontakte (5) des Stromspeichers (1) angeordnet sind.

11. Stromspeicher nach einem der Ansprüche 1 bis 10, **dadurch gekennzeichnet, dass** Kontakte (5, 7, 9) rings um den Stromspeicher herumlaufend ausgebildet sind.

12. Stromspeicher nach Anspruch 11, **dadurch gekennzeichnet, dass** wenigstens der negative Kontakt (7) und/oder wenigstens der positive Kontakt (5) rings um den Stromspeicher herumlaufend ausgebildet sind.

13. Stromspeicher nach Anspruch 11 oder 12, **dadurch gekennzeichnet, dass** an den Enden des Stromspeichers (1) vorgesehene Kontakte (7) rings um den Stromspeicher herumlaufend ausgebildet sind.

14. Stromspeicher nach einem der Ansprüche 11 bis 13, **dadurch gekennzeichnet, dass** der wenigstens eine im Bereich der Mitte des Stromspeichers (1) angeordnete Kontakt (5) rings um den Stromspeicher herumlaufend ausgebildet ist.

## Claims

1. Power accumulator (1) having an elongated shape and at least one positive and at least one negative contact (5, 7) whereby the contacts (5, 7) are arranged symmetrically with respect to the external shape of the power accumulator (1), **characterized in that** the positive and negative contacts (5, 7) are arranged symmetrically with respect to a longitudinal center plane (3) of the power accumulator (1) as plane of symmetry and that at least one contact (5) is arranged in region of the plane of symmetry (3) and two further contacts (7) are arranged with a distance from the plane of symmetry (3).

2. Power accumulator according to claim 1, **characterized in that** the power accumulator (1) has a cross sectional shape chosen from the group consisting of polygonal, rectangular, square, triangular, round or circular.

3. Power accumulator according to claim 1 or 2, **characterized in that** the contacts (7) that are arranged at a distance from the plane of symmetry (3) project over the end surfaces of the power accumulator (1).

4. Power accumulator according claim 1 or 2, **characterized in that** the contacts (7) that are at a distance from the plane of symmetry (3) are countersunk into the end surfaces of the power accumulator (1).

5. Power accumulator according to one of claims 1 to 3, **characterized in that** the contacts (7) that are arranged at a distance from the plane of symmetry (3) are arranged at the end surfaces and/or bordering regions of the outer side of the power accumulator (1).

6. Power accumulator according to claim 1 or 2, **characterized in that** the contacts (5, 7) are arranged projecting over the outer surface of the power accumulator (1).

7. Power accumulator according to one of claims 1 to 3, **characterized in that** the contacts (5, 7) are countersunk with respect to the outer surface of the power accumulator (1).

8. Power accumulator according to claim 1 or 2, **characterized in that** the contacts (5, 7) lie in the outer surface of the power accumulator (1).

9. Power accumulator (1) according to one of claims 1 to 8, **characterized in that** in the region of the plane of symmetry (3) of the power accumulator (1) at least one further contact (9) for access to a data memory located in the power accumulator (1) which contact (9) preferably extends around the power accumulator (1).

10. Power accumulator according to claim 9, **characterized in that** next to the contact (9) for access to the data memory two contacts (5) of the power accumulator (1) are arranged.

11. Power accumulator according to one of claims 1 to 10, **characterized in that** contacts (5, 7, 9) extend around the power accumulator (1).

12. Power accumulator according to claim 11, **characterized in that** at least the negative contact (7) and/or at least the positive contact (5) extends around the power accumulator (1).

13. Power accumulator according to claim 11 or 12, **characterized in that** the contacts (7) arranged at the end of the power accumulator (1) extend around the power accumulator (1).

14. Power accumulator according to one of claims 11 to 13, **characterized in that** the at least one contact (5) arranged in the region of the center of the power accumulator (1) extends around the power accumulator (1).

## Revendications

1. Accumulateur de courant (1) possédant une forme allongée et présentant au moins un contact positif et au moins un contact négatif (5, 7), les contacts (5, 7) étant disposés symétriquement par rapport à la forme extérieure de l'accumulateur de courant (1),
**caractérisé en ce que** les contacts positifs-et négatifs (5, 7) sont disposés en tant que plan de symétrie, symétriquement par rapport au plan médian longitudinal (3) de l'accumulateur de courant (1), et **en ce qu'**au moins un contact (5) est disposé dans la zone du plan de symétrie (3) et deux autres contacts (7) étant disposés à distance du plan de symétrie (3).

2. Accumulateur de courant selon la revendication 1, **caractérisé en ce que** l'accumulateur de courant (1) possède une forme en coupe transversale sélectionnée dans le groupe se composant des formes polygonale, rectangulaire, carrée, triangulaire, ronde et circulaire.

3. Accumulateur de courant selon la revendication 1 ou 2, **caractérisé en ce que** les contacts (7), qui sont disposés à distance du plan de symétrie (3), dépassent des surfaces d'extrémité de l'accumulateur de courant (1).

4. Accumulateur de courant selon la revendication 1 ou 2, **caractérisé en ce que** les contacts (7), qui sont disposés à distance du plan de symétrie (3), sont disposés de manière noyée dans les surfaces d'extrémité de l'accumulateur de courant (1).

5. Accumulateur de courant selon l'une des revendications 1 à 3, **caractérisé en ce que** les contacts (7) disposés à distance du plan de symétrie (3) sont disposés au niveau des surfaces d'extrémité et/ou des zones adjacentes du côté extérieur de l'accumulateur de courant (1).

6. Accumulateur de courant selon la revendication 1 ou 2, **caractérisé en ce que** les contacts (5, 7) sont disposés de manière à dépasser de la surface extérieure de l'accumulateur de courant (1).

7. Accumulateur de courant selon l'une des revendications 1 à 3, **caractérisé en ce que** les contacts (5, 7) sont disposés de manière noyée par rapport à la surface extérieure de l'accumulateur de courant (1).

8. Accumulateur de courant selon la revendication 1 ou 2, **caractérisé en ce que** les contacts (5, 7) se situent dans la surface extérieure de l'accumulateur de courant (1).

9. Accumulateur de courant selon l'une des revendications 1 à 8, **caractérisé en ce que**, dans la zone du plan de symétrie (3) de l'accumulateur de courant (1), au moins un autre contact (9) est disposé pour l'accès à une mémoire de données disposée dans l'accumulateur de courant (1), lequel contact (9) est de préférence formé de manière périphérique tout autour de l'accumulateur de courant (1).

10. Accumulateur de courant selon la revendication 9, **caractérisé en ce que**, mis à part le contact (9) pour l'accès à la mémoire de données, deux contacts (5) de l'accumulateur de courant (1) sont mis en place.

11. Accumulateur selon l'une des revendications 1 à 10, **caractérisé en ce que** des contacts (5, 7, 9) sont formés de manière périphérique tout autour de l'accumulateur de courant.

12. Accumulateur selon la revendication 11, **caractérisé en ce qu'**au moins le contact négatif (7) et/ou au moins le contact positif (5) sont réalisés de manière périphérique tout autour de l'accumulateur de courant.

13. Accumulateur de courant selon la revendication 11 ou 12, **caractérisé en ce que** des contacts (7) prévus aux extrémités de l'accumulateur de courant (1) sont réalisés de manière périphérique tout autour de l'accumulateur de courant.

14. Accumulateur de courant selon l'une des revendications 11 à 13, **caractérisé en ce que** cet au moins un contact (5) disposé dans la zone du milieu de l'accumulateur de courant (1) est réalisé de manière périphérique tout autour de l'accumulateur de courant.
